# EUROPEAN PATENT APPLICATION

(11) **EP 4 692 823 A1**
(43) Date of publication of application: **11.02.2026**
(21) Application number: 25187361.8
(22) Date of filing: 03.07.2025
(51) Int. Cl.: G01R 31/392, G01R 31/396

(54) **ELECTRONIC DEVICE AND METHOD FOR MONITORING HEALTH STATE OF BATTERY ASSEMBLY**

(30) Priority: 05.08.2024 CN 202411068703
(71) Applicant: Harman International Industries, Incorporated, Stamford, CT 06901 (US)
(72) Inventor: MAO, Liwen, Shenzhen, 518067 (CN); ZHONG, Bo, Shenzhen, 518067 (CN); YOU, Caihui, Shenzhen, 518067 (CN); LUO, Haixiong, Shenzhen, 518067 (CN)
(74) Representative: Rummler, Felix

(57) **Abstract**

An electronic device and a method for monitoring a health state of a battery assembly are provided. During an operation process and a charging process of a lithium battery, key parameters (such as voltage, temperature, current, and internal resistance) can be monitored in real time, and a health state of the lithium battery can be evaluated through data analysis. Embodiments of the present disclosure can not only help timely discover potential issues (such as leakage and bulge), but also provide valuable information for a battery management system and a lithium battery manufacturer, thereby optimizing a battery usage strategy and extending the service life of the battery.

## Description

### Technical Field

The present disclosure relates to electronic devices, and more specifically, to an electronic device and a method for monitoring a health state of a battery assembly.

### Background

Currently, portable devices with lithium batteries are becoming increasingly more common. Lithium batteries, with lightness thereof, have become the preferred battery type for portable devices such as smartphones, laptops, and tablets. However, due to external environmental factors (such as mechanical shock and extreme temperature) or internal factors (such as poor design, material aging, and electrochemical reaction abnormality), lithium batteries may be punctured, dropped, bulged, overheated, or the like, which may further cause safety hazards or even cause incidents such as fire or explosion.

In order to avoid lithium battery failures and improve the safety of lithium batteries, some lithium battery health state analysis algorithms have been proposed. However, these health state analysis algorithms mainly focus on parameter analysis after a failure occurs. Although these algorithms can assist in determining the cause of lithium battery failure to a certain extent, it is often difficult to determine a root cause of the lithium battery failure. Especially after a lithium battery catches fire, parameters that can be used to determine the health state of the lithium battery are no longer available, and it is therefore even more impossible to determine the cause of the lithium battery fire.

Therefore, there is a need to improve the existing health monitoring solutions for lithium batteries to avoid lithium battery failures and help manufacturers find root causes of incidents as much as possible after the battery failures occur.

### Summary of the Invention

In order to solve the above problems, the present disclosure proposes an electronic device, including: a battery assembly including: at least one sensor configured to collect a real-time value of a battery parameter when the battery assembly is charging and discharging; a first memory configured to store an extreme value of the battery parameter; a second memory configured to store the real-time value of the battery parameter within a predetermined period of time; and a functional assembly, including a communication assembly and a micro-computing unit, where the communication assembly is configured to, when the communication assembly and the micro-computing unit are powered on, acquire the extreme value of the battery parameter from the first memory; and when the communication assembly and the micro-computing unit are in operation states, acquire the real-time value of the battery parameter from the second memory periodically; and the micro-computing unit is configured to, when the communication assembly and the micro-computing unit are in the operation states, determine health state data of the battery assembly based on at least one of the extreme value of the battery parameter and the real-time value of the battery parameter acquired periodically.

An embodiment of the present disclosure further provides a method for monitoring a health state of a battery assembly, including: acquiring an extreme value of a battery parameter of the battery assembly, or periodically acquiring a real-time value of a battery parameter of the battery assembly; determining a plurality of state abnormalities of the battery assembly based on at least one of the extreme value of the battery parameter and the real-time value of the battery parameter acquired periodically; determining health state data of the battery assembly based on a contribution of the plurality of state abnormalities of the battery assembly to a failure of the battery assembly; and determining a failure cause of the battery assembly based on the health state data of the battery assembly.

According to the embodiment of the present disclosure, during an operation process and a charging process of a lithium battery, key parameters (such as voltage, temperature, current, and internal resistance) can be monitored in real time, and a health state of the lithium battery can be evaluated through data analysis. Embodiments of the present disclosure can not only help timely discover potential issues (such as leakage and bulge), but also provide valuable information for a battery management system and a lithium battery manufacturer, thereby optimizing a battery usage strategy and extending the service life of the battery.

### Brief Description of the Drawings

To describe the technical solutions of the embodiments of the present disclosure more clearly, accompanying drawings needed to be used in the descriptions of the embodiments are described in brief as follows. Apparently, the accompanying drawings described below are merely some example embodiments of the present disclosure, and other accompanying drawings can further be obtained according to these accompanying drawings by those of ordinary skill in the art without creative labor.
FIG. 1 is a schematic diagram of a system according to an embodiment of the present disclosure;
FIG. 2 is a schematic diagram of an operation period of time of a system according to an embodiment of this disclosure;
FIG. 3 is a schematic diagram of determining a power-down state of a battery assembly according to an embodiment of the present disclosure;
FIG. 4 is a schematic diagram of determining a temperature state of a battery assembly according to an embodiment of the present disclosure;
FIG. 5 is a schematic diagram of determining a charging state of a battery assembly according to an embodiment of the present disclosure;
FIG. 6 is a schematic diagram of determining a discharging state of a battery assembly according to an embodiment of the present disclosure;
FIG. 7 is a schematic diagram of determining a failure cause of a battery assembly according to an embodiment of the present disclosure; and
FIG. 8 is a schematic diagram of a method of monitoring a health state of a battery assembly according to an embodiment of the present disclosure.

### Detailed Description

To make objectives, technical solutions, and advantages of embodiments of the present disclosure more comprehensible, technical solutions of the embodiments of the present disclosure are described clearly and completely through the accompanying drawings in the embodiments of the present disclosure. Obviously, the described embodiments are only a part of the embodiments in the present disclosure, rather than all the embodiments. Moreover, without conflict, embodiments in the present disclosure and features in the embodiments may be combined together. Based on the embodiments of the present disclosure, all other embodiments derived by those of ordinary skill in the art without any creative efforts fall within the protection scope of the present disclosure.

Unless otherwise defined, the technical terms or scientific terms used in the present disclosure should have the ordinary meanings understood by those of ordinary skill in the field of the present disclosure. Similar words such as "including" and "comprising" used in the present disclosure mean that an element or object preceding the words includes elements or objects listed after the words and equivalents thereof, but do not exclude other elements or objects. Similar words such as "connected" and "connecting" are not limited to physical or mechanical connections, but may include electrical connections, whether direct or indirect. "Inside", "outside", "upper", "lower", and the like are only used to indicate relative position relationships. When an absolute position of an object being described changes, the relative position relationship may also change accordingly.

It should be noted that sizes and shapes of various figures in the accompanying drawings do not reflect the actual proportions, only aim to illustrate the contents of the present disclosure. Moreover, identical or similar reference numerals represent identical or similar elements or elements having identical or similar functions throughout the text.

Currently, more and more consumer electronic products mostly use lithium batteries as power components. These consumer electronic products include mobile phones, tablets, laptops, speakers, headphones, and other electronic devices. Lithium batteries, with their lightweight nature, become the first choice for these devices. However, unreasonable designs of some lithium batteries or incorrect uses of lithium batteries can easily lead to lithium battery failures and even cause safety incidents. When a lithium battery catches fire, it is difficult to determine a root cause of the incident.

In order to avoid lithium battery failures and improve the safety of lithium batteries, some lithium battery health state analysis algorithms have been proposed. However, these health state analysis algorithms mainly focus on parameter analysis after a failure occurs. Although these algorithms can assist in determining the cause of lithium battery failure to a certain extent, it is often difficult to determine a root cause of lithium battery failure. Especially after a lithium battery catches fire, parameters that can be used to determine the health state of the lithium battery are no longer available.

Therefore, there is a need to improve the existing health monitoring solutions for lithium batteries to avoid risks caused by lithium battery failures and help manufacturers find root causes of incidents as much as possible after the battery failures.

Therefore, the present disclosure provides an electronic device, including: a battery assembly including: at least one sensor, where the at least one sensor is configured to collect a real-time value of a battery parameter when the battery assembly is charging and discharging, and store an extreme value of the battery parameter; and a functional assembly, including a communication assembly and a micro-computing unit, where the communication assembly is configured to, when the functional assembly is powered on, acquire the extreme value of the battery parameter; and when the communication assembly and the micro-computing unit are in operation states, acquire the real-time value of the battery parameter periodically; and the micro-computing unit is configured to, when the communication assembly and the micro-computing unit are in the operation states, determine health state data of the battery assembly based on the extreme value of the battery parameter and the real-time value of the battery parameter acquired periodically.

The present disclosure further provides a method for monitoring a health state of a battery assembly, including: acquiring an extreme value of a battery parameter of the battery assembly, or periodically acquiring a real-time value of a battery parameter of the battery assembly; determining a plurality of state abnormalities of the battery assembly based on at least one of the extreme value of the battery parameter and the real-time value of the battery parameter acquired periodically; determining the health state data of the battery assembly based on a contribution of the plurality of state abnormalities of the battery assembly to a failure of the battery assembly, and determining a failure cause of the battery assembly based on the health state data of the battery assembly.

In the embodiment of the present disclosure, during a normal use and charging process of a lithium battery, key parameters (such as voltage, temperature, current, and internal resistance) can be monitored in real time, and a health state of the lithium battery can be evaluated by analyzing health state data of the battery assembly, and a battery failure cause is predicted. The embodiments of the present disclosure can not only help timely discover potential issues (such as leakage and bulge), but also provide valuable information for a battery management system and a lithium battery manufacturer, thereby optimizing a battery usage strategy and extending the service life of the battery.

Next, the present disclosure will be further described with reference to the accompanying drawings.

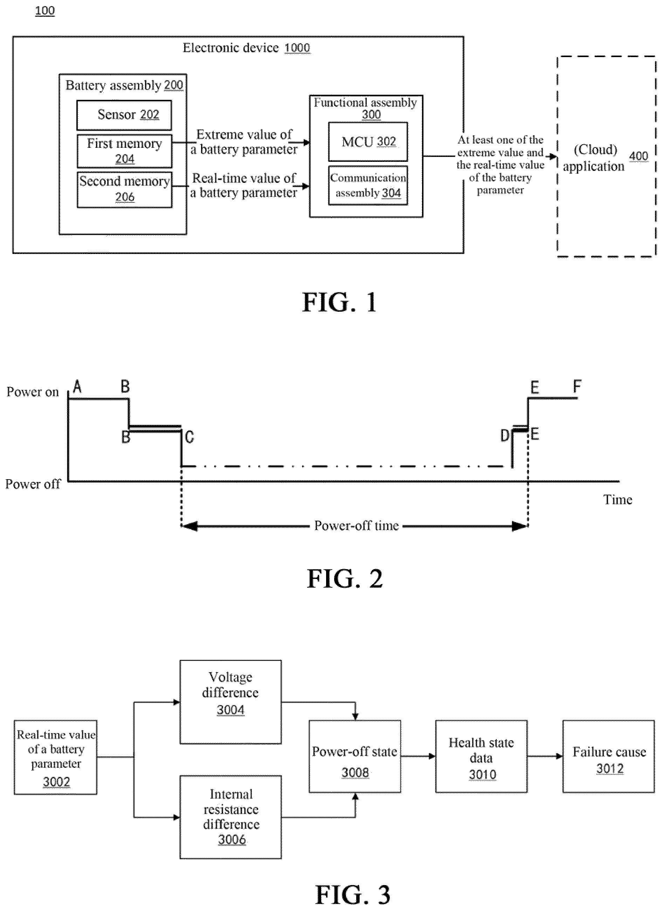

FIG. 1 is a schematic diagram of a system 100 according to an embodiment of the present disclosure, including an electronic device 1000 and a (cloud) application 400.

As shown in FIG. 1, the system 100 includes an electronic device 1000. The electronic device 1000 may be a variety of electronic products, such as a smart speaker, a portable speaker, a wearable device, or a mobile power supply. The system 100 may further optionally include the (cloud) application 400 for data storage, analysis, and remote management. The system 100 may further optionally include more or fewer components, and the present disclosure is not limited thereto.

The electronic device 1000 may include a battery assembly 200 and a functional assembly 300. The battery assembly 200 may be used as a power source for the functional assembly 300 to supply energy to the functional assembly 300. The battery assembly 200 may be designed to be replaceable and detachable from the functional assembly 300, so as to allow a user to replace the battery assembly 200 when the battery performance decreases, thereby extending the service life of the electronic device 1000. Optionally, the battery assembly 200 includes one or a plurality of lithium batteries. Of course, the battery assembly 200 may further include other types of batteries, and the present disclosure is not limited thereto.

The battery assembly 200 includes at least one sensor 202, a first memory 204, and a second memory 206. The at least one sensor 202 may be configured to collect a real-time value of a battery parameter when the battery assembly 200 is charging and discharging. The first memory 204 may be configured to store an extreme value of the battery parameter. The second memory 206 may be configured to store the real-time value of the battery parameter within a predetermined period of time. The first memory 204 is a non-volatile memory. The second memory 206 may be a volatile memory. The second memory 206 may be powered by one or a plurality of batteries in the battery assembly 200, and may lose its stored data when it loses power (or the voltage of one or a plurality of batteries in the battery assembly 200 is lower than its operating voltage). Of course, the second memory 206 may also be a non-volatile memory, and the present disclosure is not limited thereto.

Optionally, a combination of the at least one sensor 202, the first memory 204, and the second memory 206 may be referred to as a battery gauge. The battery gauge may be integrated as a component onto a mainboard of the battery assembly 200 to collect the real-time value of the battery parameter when the battery assembly 200 is charging and discharging. A period of time during which the battery assembly 200 operates includes a period of time when the battery assembly 200 is charged by an adapter and a period of time when the battery assembly 200 supplies energy to the functional assembly 300 (the battery assembly 200 is discharged at this time).

For example, the battery parameter includes at least one of the following: charging current, discharging current, battery voltage, battery capacity, internal resistance, and temperature. The first memory 204 may be configured to record and store extreme values of battery parameters of the battery assembly 200 since it is enabled, and the extreme values of the battery parameters include but are not limited to maximum charging current, minimum charging current, maximum discharging current, minimum discharging current, maximum battery voltage, minimum battery voltage, maximum battery capacity, maximum battery internal resistance, minimum battery internal resistance, maximum temperature, minimum temperature, and the like.

Optionally, when at least one sensor 202 detects that a real-time value of a battery parameter exceeds the extreme value of the battery parameter stored internally, the data stored in the first memory 204 will be updated. For example, assuming that the at least one sensor 202 detects that the current charging current is greater than the recorded maximum charging current, the at least one sensor 202 will update the value of the maximum charging current recorded in the storage unit. Of course, the present disclosure is not limited to this.

Optionally, the functional assembly 300 periodically acquires the real-time value of the battery parameter from the second memory 206. When the internal storage capacity of the functional assembly 300 reaches a preset storage capacity upper limit, the functional assembly 300 may automatically overwrite the earliest stored battery parameter with the latest collected battery parameter. In this way, functional assembly 300 is able to continuously monitor the battery performance and provide an up-to-date health state evaluation while avoiding memory overflow issues. Of course, the present disclosure is not limited to this.

The functional assembly 300 may be a core functional assembly of the electronic device 1000, and is configured to implement core functions of the electronic device 1000. Assuming that the electronic device 1000 is an audio device, the functional assembly 300 is a speaker therein, to implement a core audio output function. Specifically, the functional assembly 300 may include: a micro-computing unit (MCU) 302 and a communication assembly 304. The micro-computing unit 302 may be configured to control and manage audio output, and perform data processing and system control. The communication assembly 304 may be a Bluetooth chip, which may be configured to communicate with at least one sensor 202 to achieve transmission of battery parameters. Of course, the present disclosure is not limited to this.

For example, the communication assembly 304 may be configured to acquire the extreme value of the battery parameter when the communication assembly 304 and the micro-computing unit 302 are powered on; and to periodically acquire the real-time value of the battery parameter when the communication assembly 304 and the micro-computing unit 302 are in operation states. The micro-computing unit 302 is configured to, when the communication assembly 304 and the micro-computing unit 302 are in the operation states, determine health state data of the battery assembly 200 based on at least one of the extreme value of the battery parameter and the real-time value of the battery parameter acquired periodically. Of course, the present disclosure is not limited to this.

Optionally, the health state data of the battery assembly 200 is data indicating the performance and safety of the battery assembly 200, which can be used for subsequent evaluation of a failure cause of the battery assembly 200. The health state data of the battery assembly 200 may be a weighted sum of indicators of abnormal states of a plurality of battery assemblies 200. For example, the plurality of state abnormalities of the battery assembly 200 include at least one of the following: power-down state abnormality, temperature state abnormality, charging state abnormality, and discharging state abnormality. Each abnormal state may cause a failure of the battery assembly 200. Therefore, the health state data of the battery assembly 200 may be expressed as: *Health* = *w*1 + *w*2 + ... + *wi* + ... + *wn*, where *Health* represents the health state data, *wi* represents the contribution of the abnormal state to the failure of the battery assembly 200, and *i* represents an index of each abnormal state. A higher value of the health state data indicates a higher likelihood of a battery failure. Optionally, when the value of the health state data is greater than or equal to 60%, the battery assembly 200 may be directly powered off and a charging function of the battery assembly 200 may be disabled to avoid safety hazards caused by abnormalities of the battery assembly 200.

Optionally, wi is not a fixed value, but a dynamic value that may change with a degree to which the corresponding abnormal state deviates from a normal value. For example, if the battery parameters related to the charging state have greatly deviated from the normal value, it may be determined that the charging abnormality is highly correlated with the battery failure. In this case, the contribution corresponding to the charging state abnormality will be greater than other abnormal states. Of course, the present disclosure is not limited to this.

In addition, as shown in FIG. 1, the extreme values and real-time values of corresponding battery parameters may also be transmitted between the electronic device 1000 and the (cloud) application 400, and then the (cloud) application 400 may replace part of computing operations of the functional assembly 300 to save part of the workload of the micro-computing unit 302 of the functional assembly 300. In addition, the (cloud) application 400 may also use cloud computing technologies, big data analysis technologies, and artificial intelligence technologies to more accurately analyze the extreme values and real-time values of the collected battery parameters and quickly issue an early warning when the battery may be abnormal. In addition, the (cloud) application 400 may also analyze the usage patterns and battery performance of individual users, and the cloud application may provide personalized usage suggestions to optimize the battery life.

Therefore, in the embodiment of the present disclosure, during a normal use and charging process of a lithium battery, key parameters (such as voltage, temperature, current, and internal resistance) can be monitored in real time, and a health state of the lithium battery can be evaluated by analyzing health state data of the battery assembly 200, and a battery failure cause is predicted. The embodiments of the present disclosure can not only help timely discover potential issues (such as leakage and bulge), but also provide valuable information for a battery management system and a lithium battery manufacturer, thereby optimizing a battery usage strategy and extending the service life of the battery.

Next, a data collection process of the system 100 according to an embodiment of the present disclosure is further described with reference to FIG. 2. FIG. 2 is a schematic diagram of an operation period of time of a system 100 according to an embodiment of this disclosure.

Optionally, a period of time in which the communication assembly 304 and the micro-computing unit 302 are in operation states includes at least one of the following items: a first period of time during which the electronic device is fully operational, a second period of time after the electronic device is powered off, and a third period of time after the electronic device is boosted but not fully operational. At an end moment of the second period of time, the micro-computing unit 302 is powered down; and at a start moment of the third period of time, the micro-computing unit 302 is powered on.

Specifically, the state in which the electronic device is fully operational means that all functional assemblies of the system 100 or the electronic device 1000 are activated and running at the same time. At this point, the system 100 or the electronic device 1000 exerts all its functions, including but not limited to the full operation of core components such as other processors, other memories, display screens, and mechanical arms. In this state, the system 100 or the electronic device 1000 is able to perform complex computing tasks, process user inputs, transmit data, display information, and respond to various external stimuli, thereby realizing all the functions and performances designed for it. The state in which the electronic device is not fully operational means that part of functional assemblies of the system 100 or the electronic device 1000 are activated and running at the same time. For example, only some key assemblies may be activated and running at this time. These key assemblies are activated first and then other assemblies are controlled to be activated. These key assemblies optionally include the communication assembly 304 and the micro-computing unit 302 of the functional assembly 300. Of course, the present disclosure is not limited to this.

As shown in FIG. 2, a cycle of operation of the electronic device 1000 includes a plurality of stages. Examples of the first period of time include a period of time from a point A to a point B and a period of time from a point E to a point F; examples of the second period of time include a period of time from the point B to a point C; and examples of the third period of time include a period of time from a point D to the point E. Of course, the present disclosure is not limited to this.

Specifically, at a moment corresponding to the point A, the electronic device 1000 or the system 100 is in a state of being boosted and running smoothly. At this point, the system 100 or the electronic device 1000 is in the full operation state, and various assemblies work together to perform various functions of the device, including data processing, user interaction, or audio playback. At the point B, the user clicks a power off button, and at this point, most assemblies of the electronic device 1000 enter a dormant state, leaving only the communication assembly 304 and the micro-computing unit 302 of the functional assembly 300 in the operation states, which allows the communication assembly 304 and the micro-computing unit 302 to still obtain the real-time value of the battery parameter from at least one sensor 202 to continue to evaluate the health state of the battery assembly 200. At the point C (that is, the end moment of the second period of time), the communication assembly 304 and the micro-computing unit 302 are powered down and stop operation. Optionally, a duration of the stage from the point B to the point C may reach 1 hour. The stage from the point C to the point D represents a complete power-off state of the device, in which the functional assembly 300 does not operate, thereby achieving maximum energy saving. At the point D (that is, the start moment of the third period of time), the user clicks a power button, and at this point, the communication assembly 304 and the micro-computing unit 302 of the functional assembly 300 are awakened first. At this point, the communication assembly 304 and the micro-computing unit 302 are powered on by the battery assembly 200, and other assemblies are awakened in turn during the period of time from D to E, and at the point E, the system 100 or the electronic device 1000 is in the full operation state. Typically, the state from D to E lasts only 2 milliseconds to 500 milliseconds.

The battery parameters obtained in each period of time or at each moment in FIG. 2 will correspond to determining different abnormal states of the battery assembly 200. Therefore, according to the embodiments of the present disclosure, the health state and performance characteristics of the battery assembly 200 may be comprehensively and accurately evaluated.

Next, examples of how the functional assembly 30 determines different abnormal states of the battery assembly 200 based on the battery parameters obtained at these different moments and examples of how to determine the health state data and the cause of failure of the battery assembly 200 based on the abnormal state of the battery assembly 200 will be further described with reference to FIG. 3 to FIG. 7.

FIG. 3 is a schematic diagram of determining a power-down state 3008 of a battery assembly 200 according to an embodiment of the present disclosure.

Optionally, the process of the micro-computing unit 302 determining health state data 3010 of the battery assembly 200 includes: determining a power-down state 3008 of the battery assembly 200 based on a real-time value 3002 of the battery parameter last acquired in the second period of time and the real-time value 3002 of the battery parameter last acquired in the third period of time; determining, based on comparison of the power-down state 3008 of the battery assembly 200 with a normal power-down state of the battery assembly 200, a contribution of the abnormality of the power-down state 3008 of the battery assembly 200 to a failure of the battery assembly 200; and determining the health state data 3010 of the battery assembly 200 based on the contribution of the abnormality of the power-down state 3008 to the failure of the battery assembly 200. Of course, the present disclosure is not limited to this.

For example, a voltage difference 3004 (hereinafter referred to as a difference V_{CE}) between the real-time value of a voltage value last acquired in the second period of time (i.e., a voltage value of the battery assembly 200 obtained at the point C) and the real-time value of a voltage value last acquired in the third period of time (i.e., a voltage value of the battery assembly 200 obtained at the point E) may be calculated, and based on this, it may be determined whether the voltage of the battery assembly 200 has dropped in the process when the system 100 or the electronic device 1000 stops operation. The voltage drop situation mentioned here includes but is not limited to the voltage drop situation of the battery assembly 200 and the voltage drop situation of a single battery in the battery assembly 200.

If the difference V_{CE} deviates significantly from the normal value, it may be determined that the battery assembly 200 has a power-down abnormality. Specifically, according to different voltage intervals of the battery assembly 200, corresponding normal power-down voltage standards may be defined. In a high voltage range (3.95 V to 4.2 V), the normal power-down voltage is 6 mV/day; in a medium voltage range (3.55 V to 3.9 V), the normal power-down voltage is 0.75 mV/day; and in a low voltage range (3.1 V to 3.5 V), the normal power-down voltage is 5.25 mV/day.

Then, based on the comparison of the difference V_{CE} with the normal power-down voltage, the degree of deviation of the difference V_{CE} from the normal value is determined. The higher the degree of deviation, the higher the contribution of the abnormality of the power-down state 3008 of the battery assembly 200 to the failure of the battery assembly 200, and the higher the contribution to the health state data 3010 of the battery assembly 200. Specifically, when V_{CE} reaches or exceeds twice the normal value, the contribution is 10%, indicating that the power-down abnormality accounts for only 10% of the failure cause 3012. If V_{CE} reaches or exceeds 4 times the normal value, the contribution increases to 40%, indicating that the power-down abnormality accounts for 40% of the failure cause 3012. In the most severe case, that is, when V_{CE} reaches or exceeds 10 times the normal value, it is given a 100% contribution, and the power-down abnormality accounts for 100% of the failure cause 3012.

For example, the internal resistance difference 3006 (hereinafter referred to as the difference IR_{CE}) between the real-time value of the internal resistance value last acquired in the second period of time (i.e., an internal resistance value of the battery assembly 200 obtained at the point C) and the real-time value of an internal resistance value last acquired in the third period of time (i.e., an internal resistance value of the battery assembly 200 obtained at the point E) may be calculated, and based on this, it may be determined whether there is a situation where the internal resistance change value of the battery assembly 200 is higher than the normal value in the process when the system 100 or the electronic device 1000 stops operation. If the internal resistance change is higher than a normal value, it is likely that the internal resistance increases too quickly. The case where the internal resistance increases mentioned here includes, but is not limited to, a case where the internal resistances of all batteries in a battery pack increase and a case where the internal resistance of a single battery in the battery assembly 200 increases.

Similarly, based on the comparison of the difference IR_{CE} with the normal value of the internal resistance reduction, the degree of deviation of the difference IR_{CE} from the normal value is determined. The higher the degree of deviation, the higher the contribution of the abnormality of the power-down state 3008 of the battery assembly 200 to the failure of the battery assembly 200, and the higher the contribution to the health state data 3010 of the battery assembly 200. For example, under normal circumstances, the internal resistance between the point C and the point E should not change much. When the change in the internal resistance is greater than a certain value, there may be an abnormality failure. Specifically, when IR_{CE} is greater than or equal to 25% of the normal value, the contribution is 20%, indicating that the power-down abnormality accounts for only 20% of the failure cause 3012. If IR_{CE} is greater than or equal to 50% of the normal value, the contribution increases to 40%, indicating that the power-down abnormality accounts for 40% of the failure cause 3012. In the most severe case, that is, IR_{CE} is greater than or equal to 75% of the normal value, it is given a 100% contribution, and the power-down abnormality accounts for 100% of the failure cause 3012.

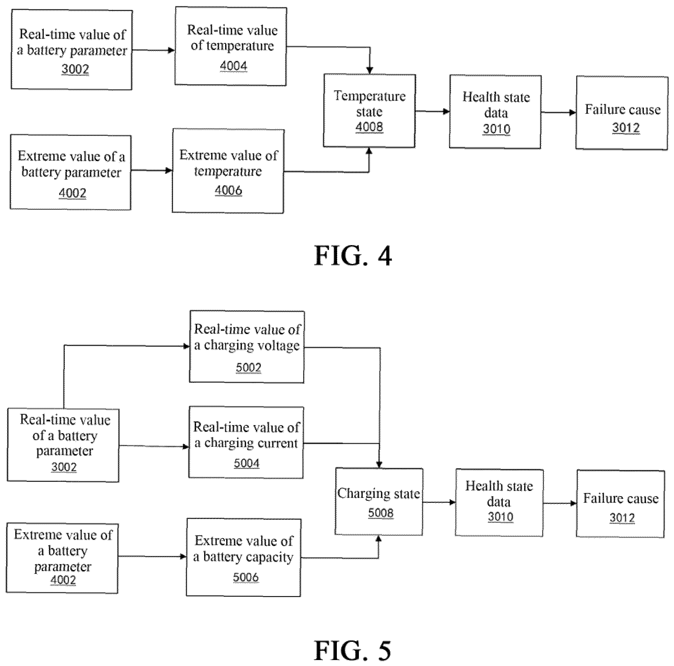

FIG. 4 is a schematic diagram of determining a temperature state 4008 of a battery assembly 200 according to an embodiment of the present disclosure.

Optionally, the process of the micro-computing unit 302 determining the health state data 3010 of the battery assembly 200 includes: determining the temperature state 4008 of the battery assembly 200 based on an extreme value 4002 of the battery parameter last acquired at the start moment of the third period of time and the real-time value 3002 of the battery parameter acquired in the third period of time; determining, based on comparison of the temperature state 4008 of the battery assembly 200 with a normal temperature state of the battery assembly 200, a contribution of the abnormality of the temperature state 4008 to a failure of the battery assembly 200; and determining the health state data 3010 of the battery assembly 200 based on the contribution of the abnormality of the temperature state 4008 of the battery assembly 200 to the failure of the battery assembly 200. Of course, the present disclosure is not limited to this.

For example, a maximum value T_{ce} between the extreme value 4006 of the temperature acquired at the start moment of the third period of time (i.e., the highest temperature of the battery assembly 200 acquired at the point D) and the real-time 4004 of the temperature last acquired at the third period of time (i.e., the real-time temperature acquired during D to E) may be calculated, and based on this, it may be determined whether there is a situation of excessively high temperature of the battery assembly 200 during the operation of the system 100 or the electronic device 1000.

If the maximum value T_{ce} deviates significantly from the normal value, it may be determined that the battery assembly 200 has a temperature abnormality. Specifically, an interval of normal values of the maximum value T_{ce} is -20°C to 60°C. Then, based on the comparison of the maximum value T_{ce} with the normal temperature increase, the degree of deviation of the maximum value T_{ce} from the normal value is determined. The higher the degree of deviation, the higher the contribution of the abnormality of the temperature state 4008 of the battery assembly 200 to the failure of the battery assembly 200, and the higher the contribution to the health state data 3010 of the battery assembly 200. Specifically, when the maximum value T_{ce} reaches or exceeds 65°C, the contribution is 20%, indicating that the temperature abnormality accounts for only 20% of the failure cause 3012. If the maximum value Tce reaches or exceeds 80°C, the contribution increases to 50%, indicating that the temperature abnormality accounts for 50% of the failure cause 3012. In the most severe case, that is, when the maximum value Tce reaches or exceeds 100°C, it is given a 100% contribution, and the temperature abnormality accounts for 100% of the failure cause 3012.

For example, a difference between the real-time value 4004 of the temperature acquired at the start moment of the third period of time (i.e., the real-time temperature of the battery assembly 200 acquired at the point D) and the real-time 4004 of the temperature last acquired at the third period of time (i.e., the real-time value 4004 of the temperature acquired during D to E) may be calculated, and based on this, it may be determined whether there is a situation of excessively quick temperature increase of the battery assembly 200 during the operation of the system 100 or the electronic device 1000. Due to the properties of lithium battery, at a boost moment, the lithium battery starts discharging, and the temperature may rise rapidly.

FIG. 5 is a schematic diagram of determining a charging state 5008 of a battery assembly 200 according to an embodiment of the present disclosure.

Optionally, the process of the micro-computing unit 302 determining the health state data 3010 of the battery assembly 200 includes: when the battery assembly 200 is charging, determining the charging state 5008 of the battery assembly 200 based on the real-time value 3002 of the battery parameter periodically acquired; determining, based on comparison of the charging state 5008 of the battery assembly 200 with a normal charging state of the battery assembly 200, a contribution of the abnormality of the charging state 5008 to a failure of the battery assembly 200; and determining the health state data 3010 of the battery assembly 200 based on the charging state 5008 of the battery assembly 200. Of course, the present disclosure is not limited to this.

For example, when the battery assembly 200 is charging, the micro-computing unit 302 may acquire the real-time value 5002 of the charging voltage, and then calculate a relationship between the voltage increase and the charging time. Specifically, the micro-computing unit 302 may calculate a time T0 required for the voltage of the battery assembly 200 to increase by 150 mV during a period of time from 7.2 V to 8.39 V. When the battery assembly 200 operates normally, the battery assembly 200 may exhibit a characteristic of a voltage increase of 150 mV every 10 minutes. If T0 deviates significantly from a normal value (10 minutes), it may be determined that the battery assembly 200 has a charging abnormality. Specifically, based on the comparison of T0 with the normal voltage increase, the degree of deviation of T0 from the normal value is determined. The higher the degree of deviation, the higher the contribution of the abnormality of the charging state 5008 of the battery assembly 200 to the failure of the battery assembly 200, and the higher the contribution to the health state data 3010 of the battery assembly 200. Specifically, when T0≤7 minutes, a contribution of 20% is assigned, indicating a slight deviation; when T0≤5 minutes, the contribution rises to 50%, indicating a moderate abnormality; and when T0≤3 minutes, the contribution reaches 100%, indicating a severe abnormality.

For another example, when the battery assembly 200 is fully charged, the micro-computing unit 302 may also acquire an extreme value 5006 of a battery capacity, and calculate a relationship between the capacity and battery state of health (SOH) and the charge cycle. Specifically, the extreme value 5006 of the battery capacity is a full charge capacity (FCC) calculated by a voltameter. The extreme value 5006 of the battery may be automatically learned and updated according to charging and discharging. For example, the FCC of a new battery is 5000 mAh, which may be updated to 5100 mAh after the first complete charge and discharge learning. After repeated use, the capacity decays and may be updated to 4000 mAh.

Specifically, the micro-computing unit 302 may calculate and record the number of times the battery assembly 200 is charged from empty battery capacity to full battery capacity and then discharged to empty battery capacity. When the battery assembly 200 operates normally, the battery capacity should still be greater than 70% of the rated capacity even after 500 cycles from insufficient battery capacity to full charge. If the battery capacity of the battery assembly 200 when fully charged is less than 70% of the rated capacity and the number of charge cycles that the battery assembly 200 may experience at this time deviates significantly from a normal value (for example, 500 times), it may be determined that the battery assembly 200 has an abnormality of the charging state 5008. Specifically, based on the comparison of the number of charge cycles with the normal value (500), a degree of deviation of the number of charge cycles from the normal value is determined. The higher the degree of deviation, the higher the contribution of the abnormality of the charging state 5008 of the battery assembly 200 to the failure of the battery assembly 200, and the higher the contribution to the health state data 3010 of the battery assembly 200. If the micro-computing unit 302 determines that the battery capacity of the battery assembly 200 when fully charged is less than 70% of the rated capacity, and the battery assembly 200 has only undergone less than or equal to 400 charge cycles, the contribution may be set to 20%. If the battery assembly 200 has only undergone less than or equal to 200 charge cycles, its battery capacity is less than or equal to 70% of the rated capacity, and the contribution may be assigned to 40%. If the battery assembly 200 has only undergone less than or equal to 100 charge cycles, its battery capacity is less than or equal to 70% of the rated capacity, and the contribution may be assigned to 100%.

In addition, the micro-computing unit 302 may determine the real-time value of the battery capacity of the battery assembly 200 when fully charged in the current charge cycle. If the battery capacity is less than or equal to 50% of the rated capacity at this time, it may be determined that the abnormality of the charging state 5008 of the battery assembly 200 has a very high contribution to the failure of the battery assembly 200. In this case, the contribution may be directly assigned to 100%.

For example, when the battery assembly 200 is charging, the micro-computing unit 302 may acquire the real-time value 5004 of the charging current. When the battery assembly 200 operates normally, the maximum charging current of the battery assembly 200 is 2A. If the charging current is greater than 2.5 A, it may be determined that the battery assembly 200 has a charging abnormality, and the contribution of the charging abnormality to the failure of the battery assembly 200 is very high. At this time, the contribution may be directly assigned to 100%.

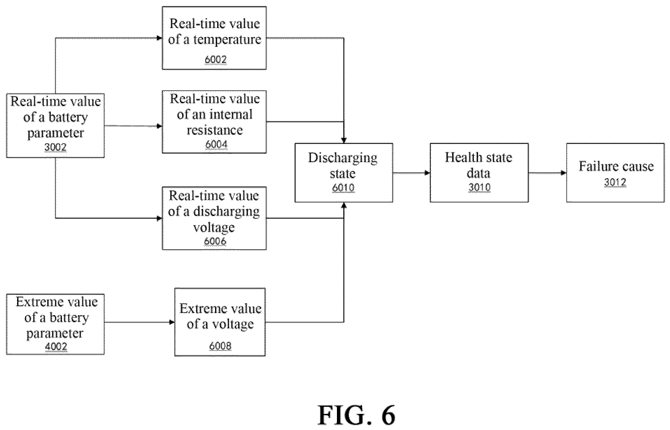

FIG. 6 is a schematic diagram of determining a discharging state 6010 of a battery assembly 200 according to an embodiment of the present disclosure.

Optionally, the process of the micro-computing unit 302 determining the health state data 3010 of the battery assembly 200 includes: when the battery assembly 200 is discharging, determining the discharging state 6010 of the battery assembly 200 based on the real-time value 3002 of the battery parameter periodically acquired; determining, based on comparison of the discharging state 6010 of the battery assembly 200 with a normal discharging state of the battery assembly 200, a contribution of the abnormality of the discharging state 6010 to a failure of the battery assembly 200; and determining the health state data 3010 of the battery assembly 200 based on the contribution of the abnormality of the discharging state 6010 of the battery assembly 200 to the failure of the battery assembly 200. Of course, the present disclosure is not limited to this.

For example, when the battery assembly 200 is discharging, the micro-computing unit 302 may acquire the real-time value 6002 of the temperature, and then calculate a relationship between the temperature increase and the discharging time. Specifically, the micro-computing unit 302 may calculate a time T1 required for the temperature of the battery assembly 200 to increase by 3°C. When the battery assembly 200 discharges normally, the battery assembly 200 may exhibit a characteristic of a temperature increase of 1.8°C every 10 minutes. If T1 deviates significantly from a normal value, it may be determined that the battery assembly 200 has a discharging abnormality. Specifically, based on the comparison of T1 with the normal temperature increase, the degree of deviation of T1 from the normal value is determined. The higher the degree of deviation, the higher the contribution of the abnormality of the discharging state 6010 of the battery assembly 200 to the failure of the battery assembly 200, and the higher the contribution to the health state data 3010 of the battery assembly 200. Specifically, when the battery assembly 200 discharges and the temperature increases by 3°C within 40 seconds, a contribution of 20% is assigned, indicating a slight deviation; when the battery assembly 200 discharges and the temperature increases by 3°C within 20 seconds, the contribution rises to 60%, indicating a moderate abnormality; and when the battery assembly 200 discharges and the temperature increases by 3°C within 10 seconds, the contribution reaches 100%, indicating a severe discharging abnormality.

For another example, when the battery assembly 200 is discharging, the micro-computing unit 302 may also acquire a real-time value 6004 of the internal resistance and compare it with a normal value. Specifically, the micro-computing unit 302 may calculate and record the internal resistances of the battery assembly 200 at 25°C, 60°C, and -20°C. When the battery assembly 200 operates normally, the internal resistance of the battery should not deviate significantly from the normal value even after 500 cycles from full battery capacity to full discharge (i.e., discharge cycles) or 500 cycles from insufficient battery capacity to full charge (i.e., charge cycles). Specifically, based on the comparison of the internal resistance of the battery with the normal value, the degree of deviation of the internal resistance of the battery from the normal value is determined. The higher the degree of deviation, the higher the contribution of the abnormality of the discharging state 6010 of the battery assembly 200 to the failure of the battery assembly 200, and the higher the contribution to the health state data 3010 of the battery assembly 200. If the micro-computing unit 302 determines that the real-time value of the internal resistance has been 4 times the normal value, and at this point, the number of discharge cycles or charge cycles experienced by the battery assembly 200 is less than or equal to 500 times, the contribution may be set to 20%. If the micro-computing unit 302 determines that the real-time value of the internal resistance has been 4 times the normal value, and at this point, the number of discharge cycles or charge cycles experienced by the battery assembly 200 is less than or equal to 300 times, the contribution may be set to 40%. If the micro-computing unit 302 determines that the real-time value of the internal resistance has been 4 times the normal value, and at this point, the number of discharge cycles or charge cycles experienced by the battery assembly 200 is less than or equal to 100 times, the contribution may be set to 100%.

For example, when the battery assembly 200 is discharging, the micro-computing unit 302 may acquire the real-time value 6006 of the discharging voltage or the extreme value 6008 of the discharging voltage. When the battery assembly 200 operates normally, the lowest voltage of the battery assembly 200 should not be lower than 2.5 V. If the real-time value 6006 of the discharging voltage or the extreme voltage 6008 of the discharging voltage has been less than 2 V or even reached 0 V, it may be determined that the battery assembly 200 has a discharging abnormality, and the contribution of the discharging abnormality to the failure of the battery assembly 200 may be assigned to 20%.

Optionally, the micro-computing unit 302 may further be configured to determine the failure cause 3012 of the battery assembly 200 based on the health state data 3010 of the battery assembly 200, where the failure cause 3012 includes at least one of the following: battery leakage, battery swelling, and lithium plating. Of course, the present disclosure is not limited to this.

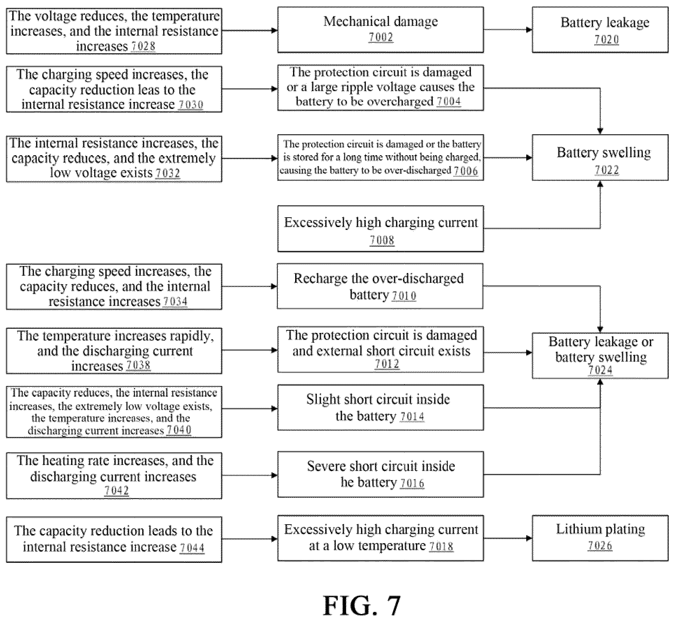

Next, how to determine the failure cause 3012 of the battery assembly 200 based on the health state data 3010 of the battery assembly 200 is further illustrated with reference to FIG. 7. FIG. 7 is a schematic diagram of determining a failure cause 3012 of a battery assembly 200 according to an embodiment of the present disclosure.

For example, with reference to FIG. 3 to FIG. 6, if the health state data increases or reaches a preset threshold due to a power-down state abnormality, a temperature state abnormality, or a discharging state abnormality, a battery failure may be caused by battery leakage. Specifically, if one or a plurality of the power-down state abnormality due to the voltage reduction, the temperature state abnormality due to the temperature increase, and the discharging abnormality due to the internal resistance increase occur 7028, it is very likely that the battery assembly 200 has a mechanical damage 7002, which in turn causes battery leakage 7020.

For another example, if the health state data 3010 increases or reaches a preset threshold due to the charging state abnormality and the discharging state abnormality, it may be a battery failure caused by battery swelling. Specifically, if one or a plurality of the charging state abnormality due to the charging speed increase and the capacity reduction, and the discharging abnormality due to the internal resistance increase occur 7030, there is a high probability that the protection circuit inside the battery assembly 200 is damaged or a large ripple voltage causes the battery to be overcharged 7004, which in turn causes battery swelling 7022 (bulging).

For another example, if the health state data 3010 increases or reaches a preset threshold due to the charging state abnormality and the discharging state abnormality, it may be a battery failure caused by battery swelling. Specifically, if one or a plurality of the power-down state abnormality due to the internal resistance increase, the charging state abnormality due to the capacity reduction, and the discharging state abnormality due to the extremely low voltage occur 7032, there is a high probability that the protection circuit inside the battery assembly 200 is damaged or the battery is stored for a long time without being charged, causing the battery to be over-discharged 7006, which in turn causes the battery swelling 7022.

For another example, if the health state data 3010 increases or reaches a preset threshold only due to the charging state abnormality, it may be a battery failure caused by the battery swelling. Specifically, if a charging state occurs due to an excessively high charging current 7008, there is a high probability that the battery swelling 7022 occurs.

For another example, if the health state data 3010 increases or reaches a preset threshold due to the charging state abnormality and the power-down state 3008 abnormality, it may be a battery failure caused by battery leakage or battery swelling. Specifically, if one or a plurality of the charging state abnormality due to the charging speed increase or capacity reduction, and the power-down abnormality due to the internal resistance increase occur 7034, it is highly likely that battery leakage or battery swelling 7024 is caused by recharging the over-discharged battery.

For another example, if the health state data 3010 increases or reaches a preset threshold due to the temperature state 4008 abnormality and the discharging state 6010 abnormality, it may be a battery failure caused by battery leakage or battery swelling. Specifically, if one or a plurality of the temperature state abnormality due to the rapid temperature increase and the discharging state abnormality due to the discharging current increase occur 7038, it is highly likely that battery leakage or battery swelling 7024 is caused by damage to the protection circuit and external short circuit 7012.

For another example, if the health state data increases or reaches a preset threshold due to the charging state abnormality, the power-down state abnormality, the temperature state abnormality, and the discharging state abnormality, it may be a battery failure caused by battery leakage or battery swelling. Specifically, if one or a plurality of the charging state abnormality due to the capacity reduction, the power-down state abnormality due to the internal resistance increase, the discharging state abnormality due to the extremely low voltage, the temperature state abnormality due to the temperature increase, and the discharging state abnormality due to the discharging current increase occur 7040, it is highly likely that battery leakage or battery swelling 7024 is caused by a slight short circuit 7014 inside the battery.

For another example, if the health state data 3010 increases or reaches a preset threshold due to the temperature state abnormality and the discharging state abnormality, it may be a battery failure caused by battery leakage or battery swelling. Specifically, if one or a plurality of the temperature state abnormality due to the rapid temperature increase and the discharging state abnormality due to the discharging current increase occur 7042, it is highly likely that battery leakage or battery swelling 7024 is caused by a severe short circuit 7016 inside the battery.

For another example, if the health state data 3010 increases or reaches a preset threshold due to the charging state abnormality and the power-down state abnormality, it may be lithium plating. Specifically, if one or a plurality of the charging state abnormality due to the capacity reduction, and the power-down state abnormality due to the internal resistance increase occur 7044, it is highly likely that lithium plating 7026 is caused by an excessively high charging current 7018 at a low temperature.

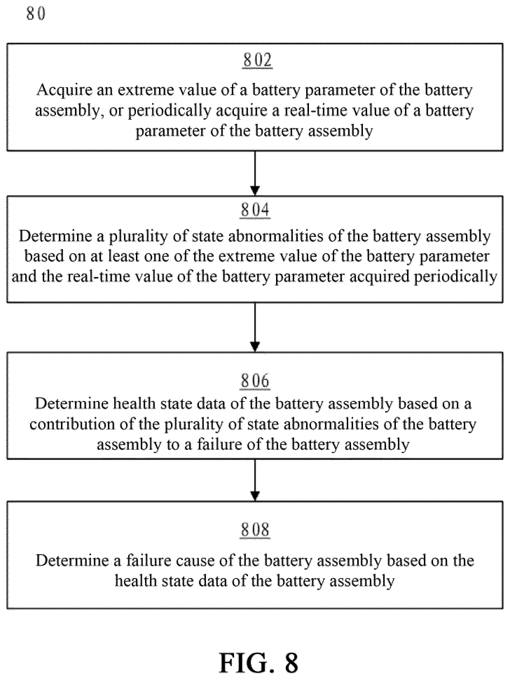

FIG. 8 is a schematic diagram of a method 80 of monitoring a health state of a battery assembly 200 according to an embodiment of the present disclosure.

As shown in FIG. 8, the method 80 for monitoring a health state of the battery assembly 200 includes operations 802 to 808.

At the operation 802, an extreme value 4002 of a battery parameter of the battery assembly 200 is acquired, or a real-time value 3002 of a battery parameter of the battery assembly 200 is periodically acquired.

At the operation 804, a plurality of state abnormalities of the battery assembly 200 are determined based on at least one of the extreme value 4002 of the battery parameter and the real-time value 3002 of the battery parameter acquired periodically.

At the operation 806, health state data 3010 of the battery assembly 200 is determined based on a contribution of the plurality of state abnormalities of the battery assembly 200 to a failure of the battery assembly 200.

At the operation 808, a failure cause 3012 of the battery assembly 200 is determined based on the health state data 3010 of the battery assembly 200.

Optionally, the battery parameter includes at least one of the following: charging current, discharging current, battery voltage, battery capacity, internal resistance, and temperature. The plurality of state abnormalities of the battery assembly 200 include at least one of the following: power-down state abnormality, temperature state abnormality, charging state abnormality, and discharging state abnormality. The failure cause includes at least one of the following: battery leakage, battery swelling, and lithium plating.

The details of the method 80 have been described in detail with reference to FIG. 1 to FIG. 7, and will not be repeated herein.

Therefore, according to the embodiment of the present disclosure, during an operation and charging process of a lithium battery, key parameters (such as voltage, temperature, current, and internal resistance) can be monitored in real time, and a health state of the lithium battery can be evaluated through data analysis. Embodiments of the present disclosure can not only help timely discover potential issues (such as leakage and bulge), but also provide valuable information for a battery management system and a lithium battery manufacturer, thereby optimizing a battery usage strategy and extending the service life of the battery.

It should be noted that the flowcharts and block diagrams in the drawings illustrate possible architectures, functions, and operations of systems, methods, and computer program products according to various embodiments of the present disclosure. In this regard, each block in the flow chart or block diagram may represent a module, a program segment, or a part of codes, and the module, the program segment or the part of codes includes one or more executable instructions used for implementing specified logic functions. It should be also noted that, in some alternative implementations, functions marked in the blocks may occur in an order different from that marked in the accompanying drawing. For example, two blocks shown in succession may actually be executed substantially in parallel, or they may sometimes be executed in the reverse order, depending on the functionality involved. It should be further noted that, each block in the block diagrams and/or flow charts and a combination of blocks in the block diagrams and/or flow charts may be implemented by using a dedicated hardware-based system used for executing specified functions or operations, or may be implemented by using a combination of dedicated hardware and a computer instruction.

Generally speaking, various exemplary embodiments of the present disclosure may be implemented in hardware or a dedicated circuit, software, firmware, logic, or any combination thereof. Some aspects may be implemented in hardware, and other aspects may be implemented in firmware or software executed by a controller, a microprocessor, or another computing device. When various aspects of the embodiment of the present disclosure are shown or described as block diagrams, flow charts or indicated by using some other graphics, it is understood that the block, apparatus, system, technology or method described herein may be implemented as non-limitative examples in the hardware, software, firmware, dedicated circuit or logic, universal hardware or controller or an other computing device, or some combinations thereof.

The example embodiments of the present disclosure described in detail above are illustrative only and not restrictive. Those skilled in the art should understand that various modifications and combinations may be made to these embodiments or features thereof without departing from the principles and spirit of the present disclosure, and such modifications should fall within the scope of the present disclosure.

## Claims

1. An electronic device, comprising:
a battery assembly, comprising:
at least one sensor configured to collect a real-time value of a battery parameter when the battery assembly is charging and discharging;
a first memory configured to store an extreme value of the battery parameter; and
a second memory configured to store the real-time value of the battery parameter within a predetermined period of time;
a functional assembly, comprising a communication assembly and a micro-computing unit, wherein
the communication assembly is configured to
when the communication assembly and the micro-computing unit are powered on, acquire the extreme value of the battery parameter from the first memory; and
when the communication assembly and the micro-computing unit are in operation states, acquire the real-time value of the battery parameter from the second memory periodically; and
the micro-computing unit is configured to
when the communication assembly and the micro-computing unit are in the operation states, determine health state data of the battery assembly based on at least one of the extreme value of the battery parameter and the real-time value of the battery parameter acquired periodically.

2. The electronic device according to claim 1, wherein the period of time during which the communication assembly and the micro-computing unit are in the operation states comprises at least one of the following:
a first period of time during which the electronic device is fully operational, a second period of time after the electronic device is powered off, and a third period of time after the electronic device is boosted but not fully operational;
wherein at an end moment of the second period of time, the micro-computing unit is powered down; and
at a start moment of the third period of time, the micro-computing unit is powered on.

3. The electronic device according to claim 2, wherein the determining health state data of the battery assembly comprises:
determining a power-down state of the battery assembly based on the real-time value of the battery parameter last acquired in the second period of time and the real-time value of the battery parameter last acquired in the third period of time;
determining, based on a comparison of the power-down state of the battery assembly with a normal power-down state of the battery assembly, a contribution of an abnormality of the power-down state of the battery assembly to a failure of the battery assembly; and
determining the health state data of the battery assembly based on the contribution of the abnormality of the power-down state to the failure of the battery assembly.

4. The electronic device according to claim 2 or 3, wherein the determining health state data of the battery assembly comprises:
determining a temperature state of the battery assembly based on the extreme value of the battery parameter acquired at the start moment of the third period of time and the real-time value of the battery parameter acquired in the third period of time;
determining, based on a comparison of the temperature state of the battery assembly with a normal temperature state of the battery assembly, a contribution of an abnormality of the temperature state to a failure of the battery assembly; and
determining the health state data of the battery assembly based on the contribution of the abnormality of the temperature state of the battery assembly to the failure of the battery assembly.

5. The electronic device according to claim 2, 3 or 4, wherein the determining health state data of the battery assembly comprises:
determining, based on the real-time value of the battery parameter acquired periodically, a charging state of the battery assembly when the battery assembly is charging;
determining, based on a comparison of the charging state of the battery assembly with a normal charging state of the battery assembly, a contribution of an abnormality of the charging state to a failure of the battery assembly; and
determining the health state data of the battery assembly based on the contribution of the charging state of the battery assembly to the failure of the battery assembly.

6. The electronic device according to any of claims 2 to 5, wherein the determining health state data of the battery assembly comprises:
determining, based on the real-time value of the battery parameter acquired periodically, a discharging state of the battery assembly when the battery assembly is discharging;
determining, based on a comparison of the discharging state of the battery assembly with a normal discharging state of the battery assembly, a contribution of an abnormality of the discharging state to a failure of the battery assembly; and
determining the health state data of the battery assembly based on the contribution of the abnormality of the discharging state of the battery assembly to the failure of the battery assembly.

7. The electronic device according to any preceding claim, wherein the battery parameter comprises at least one of the following: charging current, discharging current, battery voltage, battery capacity, internal resistance, and temperature.

8. The electronic device according to any preceding claim, wherein the micro-computing unit is further configured to:
determine a failure cause of the battery assembly based on the health state data of the battery assembly,
wherein the failure cause comprises at least one of the following: battery leakage, battery swelling, and lithium plating.

9. A method for monitoring a health state of a battery assembly, comprising:
acquiring an extreme value of a battery parameter of the battery assembly, or periodically acquiring a real-time value of a battery parameter of the battery assembly;
determining a plurality of state abnormalities of the battery assembly based on at least one of the extreme value of the battery parameter and the real-time value of the battery parameter acquired periodically;
determining health state data of the battery assembly based on a contribution of the plurality of state abnormalities of the battery assembly to a failure of the battery assembly, and
determining a failure cause of the battery assembly based on the health state data of the battery assembly.

10. The method according to claim 9, wherein
the battery parameter comprises at least one of the following: charging current, discharging current, battery voltage, battery capacity, internal resistance, and temperature;
the plurality of state abnormalities of the battery assembly comprise at least one of the following: power-down state abnormality, temperature state abnormality, charging state abnormality, and discharging state abnormality; and
the failure cause comprises at least one of the following: battery leakage, battery swelling, and lithium plating.
